Europäisches Patentamt

European Patent Office

Office européen des brevets

(11) Publication number: **0 190 823 B1**

# EUROPEAN PATENT SPECIFICATION

(45) Date of publication of patent specification: **28.08.91**  (51) Int. Cl.⁵: **G11C 7/00**

(21) Application number: **86300217.6**

(22) Date of filing: **15.01.86**

(54) **Precharge circuit.**

(30) Priority: **31.01.85 US 696624**

(43) Date of publication of application:
**13.08.86 Bulletin  86/33**

(45) Publication of the grant of the patent:
**28.08.91 Bulletin  91/35**

(84) Designated Contracting States:
**DE FR GB IT**

(56) References cited:
**EP-A- 0 098 164**

(73) Proprietor: **International Business Machines Corporation**
**Old Orchard Road**
**Armonk, N.Y. 10504(US)**

(72) Inventor: **Rajeevakumar, Thekkemadathil Velayudan**
**107 Lakeview Avenue**
**Scarsdale New York 10583(US)**
Inventor: **Terman, Lewis Madison**
**Twin Lakes Road**
**South Salem New York 10590(US)**

(74) Representative: **Bailey, Geoffrey Alan**
**IBM United Kingdom Limited Intellectual Property Department Hursley Park**
**Winchester Hampshire SO21 2JN(GB)**

## Description

The present invention relates to precharge circuits for generating a precharge clock output signal.

Various precharge circuits for memory arrays are known in the prior art.

In US-A-4,208,730, the bit lines of a word organized memory array are precharged to a potential which is substantially equal to the flip points of the memory cells of the array prior to each read and each write operation. This ensures the non-disturbance of the unselected memory cells of the array, provides greater design freedom of the memory array components, and enables the memory array to operate faster and more reliably.

In Japanese Patent No. 56-165983 issued 19 December 1981 (= GB-A-2 070 372), a circuit is provided to enable high speed operation, by starting the precharge through the detection of change in the memory cycle at an address input transit detecting circuit and completing the precharge according to the bit line bit voltage. When any of the address input signals is changed, an input transition detecting circuit detects this and memory cells are turned on in response to the rise of a succeeding synchronizing control signal to start precharging of each bit line. The charging voltage of the lines is detected and when either one output is at 0, a circuit is set to complete the precharge. Thus, the precharge period is not made longer than required and high speed processing can be made for a semiconductor storage device.

In US-A- 4,338,679, a circuit is disclosed for use in a semiconductor integrated circuit memory. The integrated circuit memory includes row lines which serve to activate access transistors for memory cells within the memory circuit. A row decoder circuit receives a plurality of first address bits and produces a drive signal output when the decoder circuit is selected. A transition detector circuit produces a transition signal whenever the state of any of the address bits is changed. A clock decoder receives a plurality of second address bits together with the transition signal to produce a selected clock signal. The combination of the transition signal and the output of the row decoder circuit serves to precharge the gate terminals of the row driver transistor for the row lines. The selected row line receives the active state of the clock signal which causes the gate terminal of the selected row driver transistor to be capacitively coupled to a higher voltage than the clock signal to therefore supply the full clock signal voltage to the row line. The voltage on the row line then activates the access transistors for the memory cells on the row line. This enables a maximum charge to be stored in or read from the memory cell.

US-A- 4,355,377 discloses a static random access memory in which fully asynchronous active equilibration and precharging of the RAM's bit lines provides improved memory access time and lower active power dissipation. Each change in the row address of the memory is sensed for developing a clock pulse of a controlled duration. The clock pulse is received by a group of equilibrating transistors and a group of precharging transistors which are coupled to the bit lines of the memory. When the clock pulse occurs, all the above mentioned transistors conduct to effect simultaneous equilibration and pre-charging of the bit lines.

In US-A- 3,942,037 an edge sensing circuit is implemented using MOS logic gates. The edge sense circuit detects either a positive transition or a negative transition of a first input signal depending on the logic level of a second input signal, if an enable signal logical "1" is applied to the edge sense circuit. If the enable signal is at a logical "0", however, a level, rather than a transition, of the input signal is detected.

US-A- 3,909,631 discloses a precharge voltage generator for use in an MOS memory matrix device wherein a voltage is generated which is midway between the voltage stored designating a logical 1 and a logical 0. This voltage is constantly variable to track changes in $V_{DD}$ and $V_T$ during circuit operation to provide the desired midvoltage level and thereby allow accurate recognition of logic levels.

US-A- 4,322,825 discloses a flexible hidden refresh memory circuit and US-A- 4,110,840 describes a sense line charging system for random access memory.

The present invention differs from the prior art in that it incorporates the concept of a self-timed precharge circuit using a novel falling edge detector scheme to generate the precharge signal for high-performance CMOS RAMs. The advantages of the proposed circuit compared to other precharge circuits include the fact that by employing such a falling edge detector means, the precharge signal is guaranteed not to be generated before the wordline has reset. Also minimal dc power is dissipated, and the timing skews that would result if a separate timing chain was used are entirely eliminated.

An object of the present invention is to provide an improved means for triggering precharge circuits for memory arrays.

Another object of the present invention is to provide a self-timed precharge circuit using a novel falling edge detector technique to generate the precharge signal.

A further object of the present invention is to provide an improved precharge circuit for CMOS RAMs which uses minimal dc power, eliminates timing skews and includes its own clock circuit.

The scope of the invention is defined by the appended claims, and how it can be carried into effect is hereinafter particularly described, with reference to the accompanying drawings, in which:-

FIG. 1 is a block diagram showing a precharge circuit of the present invention in combination with other elements of a memory array.

FIG. 2 is a circuit diagram of one embodiment of edge detector circuit which may be incorporated in the precharge circuit according to the present invention;

FIG. 3 is a graph illustrating curves of voltage vs time useful in explaining the operation of the precharge circuit;

FIG. 4 is a schematic circuit diagram of a precharge circuit according to the present invention; and

FIG. 5 is a timing chart of signals useful in explaining the circuit of FIG. 4.

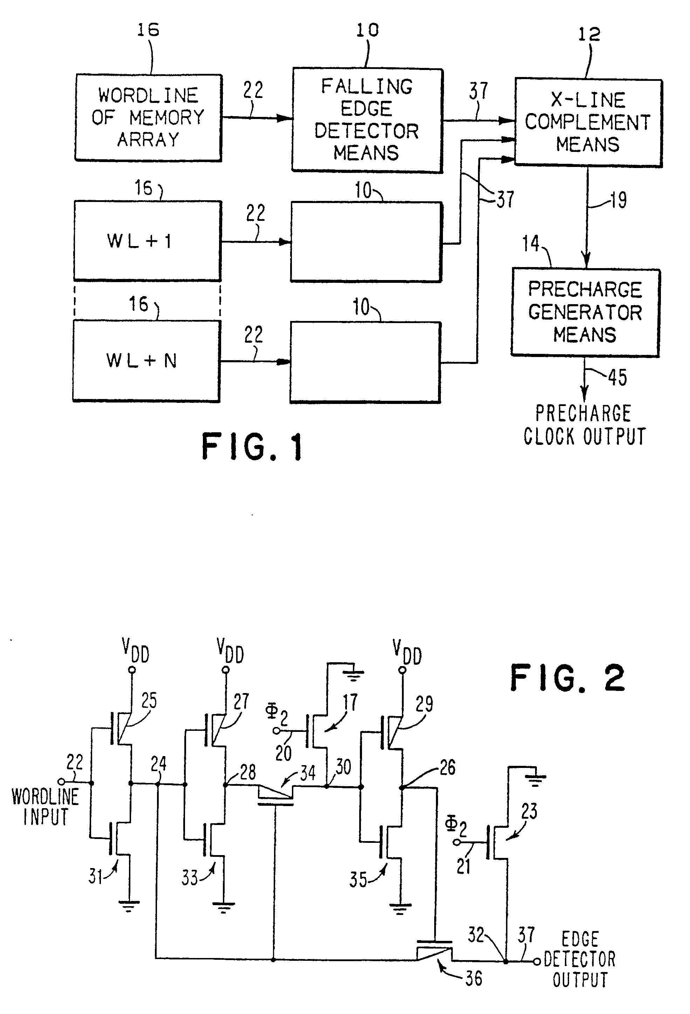

An embodiment of self-timed precharge circuit according to the present invention (Figure 1) consists of an X-line complement means 12 connected to the outputs of a plurality of identical falling edge detector means 10, and a precharge generator means 14. Each falling edge detector means 10 is connected by a lead 22 to a separate wordline 16 (WL, WL + 1,...WL + N) of a system memory array. In operation, the precharge generator means 14 is triggered by a signal on line 19 from X-line complement means 12, which is triggered by a signal on a lead 37 from one of the multiplicity of falling edge detector means 10 which is activated when the selected wordline (WL, WL + 1,...WL + N) connected thereto resets.

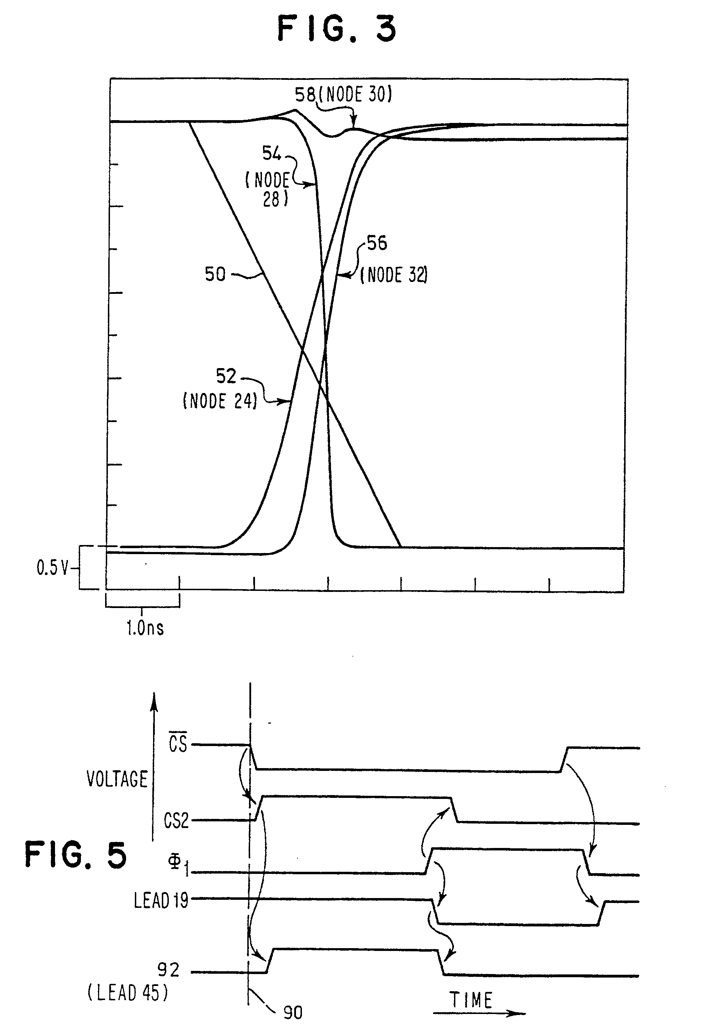

In a circuit embodiment of falling edge detector means 10 (FIG. 2), transistor devices 25, 27, 29, 34 and 36 (illustrated with slant lines) are p-channel MOSFET devices, and transistor devices 17, 23, 31, 33 and 35 are n-channel MOSFET devices. A reset signal $\phi_2$ is applicable on lead 20 and lead 21 to the respective bases of transistors 17 and 23. At the beginning of a cycle, the input wordline signal on lead 22 is low and reset signal $\phi_2$ on leads 20 and 21 is high. Nodes 24 and 26 are high and node 28 is low. Nodes 30 and 32 are precharged low. The detector circuit is initiated by reset signal $\phi_2$ going low, turning off the associated n-channel MOSFET transistor devices 17 and 23. Now when the wordline input signal on lead 22 goes high, node 24 goes low, resulting in node 28 going high and p-channel MOSFET transistor device 34 turning on. This results in node 30 being pulled high and thus node 26 goes low. Node 26 going low turns on transistor device 36, keeping node 32 and output lead 37 (the edge detector output) low.

When the wordline input signal on lead 22 then goes low, node 24 goes high turning off p-channel transistor device 34 and thereby keeping node 30 high. Node 26 remains low and p-channel transistor device 36 remains on. Thus, the node 32 and output lead 37 are charged up to $V_{DD}$ from node 24 through transistor device 36 and the edge detector output goes high.. Near the end of the cycle, reset signal $\phi_2$ on leads 20 and 21 goes high, nodes 30 and 32 and output lead 37 are once again precharged low and the circuit is ready for a new cycle.

The variation of voltage with time at selected points of the circuit (FIG. 3) during the operation of the falling edge detector means 10, shows that when the signal 50 on the input wordline 16 falls, the voltage 52 at node 24 goes high, followed by the voltage 54 at node 28 going low and the voltage 56 at node 32 going high. Thus the output of the falling edge detector means on output lead 37 goes high. The voltage 58 at node 30, which stores the high-voltage state, is only lightly perturbed when node 28 is discharged to a low.

The complete precharge clock generation means (Fig, 4) includes the falling edge detector means 10, X-line complement means 12, and precharge clock generator means 14.

The X-line complement circuit 12 includes an n channel transistor device 60 for each falling edge detector means 10, the corresponding leads 37 being connected to the respective bases of the transistors 60. The output lead 19 is from a node 62 connected by a common lead 64 to the nongrounded sides of the transistors 60. The lead 64 is connected to ground through a capacitor 66. The node 62 is connected through a p channel transistor device 68 to a voltage source $V_{DD}$. A reset signal $\phi_1$, which is complementary to the reset signal $\phi_2$, is applicable to the base of the transistor device 68. Thus the signals on leads 37 are NORed in the X-line complement circuit 12.

In the precharge clock generator means 14, the signal on lead 19 is applied to the bases of channel transistor device 70 and n channel transistor device 72. Node 43 between transistors 70 and 72 is also connected to voltage source $V_{DD}$ through p channel transistor device 74, and to the bases of p channel transistor device 76 and n channel transistor device 78. Node 80 between transistors 76 and 78 provides the precharge clock output on lead 45. An internal chip select signal CS2 is applicable to a node 82 connected through n channel and p channel transistor devices 84 and 86 to a node 41. Reset signal $\phi_2$ is applicable to the base of transistor 84 and reset signal $\phi_1$ is applicable to the base of transistor 86. Node 41 is connected to the base of transistor 74 and to the base of n-channel transistor device 88 through which transistor 72 is connected to ground.

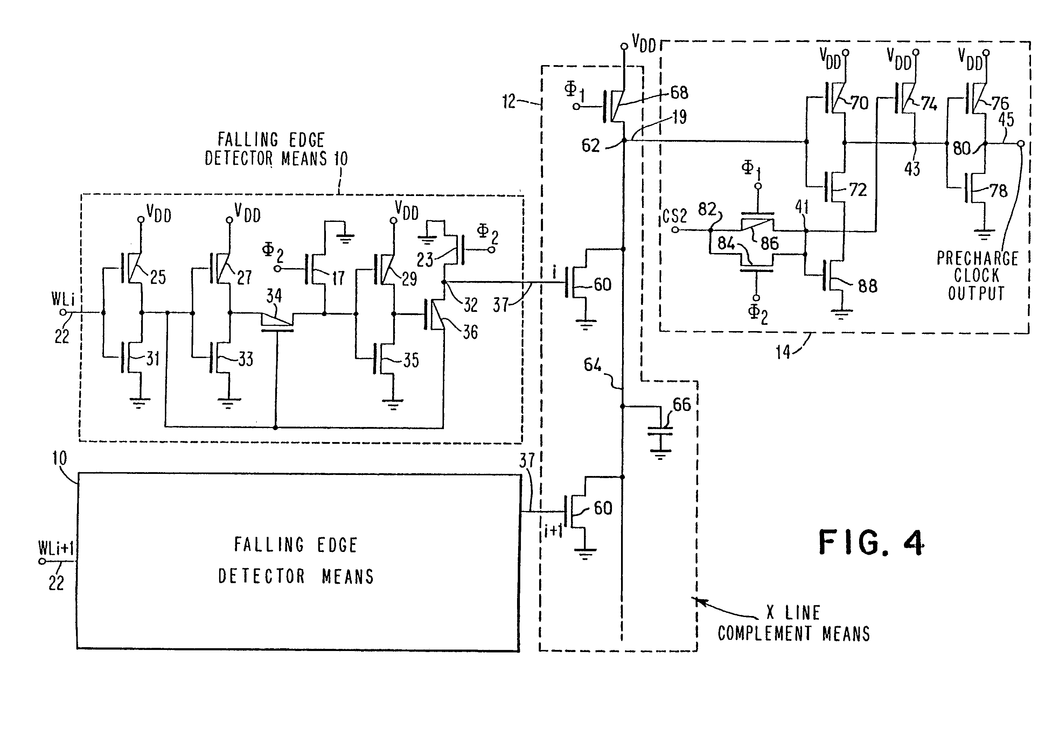

The fall of a system chip not select not signal CS (Fig. 5) initiates rise of internal chip select signal CS2. The X-line complement output signal on lead 19 (Fig. 4) and the internal chip select (CS2) signal are NANDed and the signal node 43 is inverted by the two devices 76 and 78 connected between node 43 and node 80 to form the output signal of the precharge clock generator means 14 on lead 45.

At the beginning 90 (Fig. 5) of a cycle of operation, all outputs on leads 37 of the falling edge detector means 10 are low. Reset signal $\emptyset_1$, is low and its complement signal $\emptyset_2$ is high. Chip select signal CS2, derived from chip not select signal CS, is low. Thus, the output signal from the X-line complement means 12 on lead 19 is high. The signal at node 41 of precharge generator means 14 is low and the signal at node 43 is high. The precharge clock output signal 92 on lead 45 from precharge generator means 14 is low.

The cycle of operation is started or triggered by the system chip not select signal CS going low followed by the chip select signal CS2 derived therefrom going high. Node 41 goes high and the precharge clock output signal on lead 45 goes high. After access to valid data has been completed, reset signal $\emptyset_1$ goes high to $V_{DD}$ and reset signal $\emptyset_2$ is discharged to ground. This keeps node 41 of the precharge generator means 14 high.

Then the wordline access goes on and a selected wordline 16 goes high and all output leads 37 from all the falling edge detector means 10 stay low. When the selected wordline 16 goes low, the particular falling edge detector means 10 connected thereto responds to the falling signal ("falling edge") and the output signal on its output lead 37 goes high, as described previously. This results in the output from X-line complement means 12 on lead 19 going low. Node 43 of precharge generator means 14 goes high and, therefore, the precharge clock output signal 92 on lead 45 goes low, initiating the precharge cycle. Later, near the end of the cycle, reset signal $\emptyset_1$ is discharged low and its complement signal $\emptyset_2$ goes high so that the circuit is precharged and ready for the next cycle.

It should be noted that even if the internal chip select signal CS2 goes low before the selected wordline resets, the precharge clock output signal on lead 45 does not go low until the selected wordline has reset.

It should be further noted that the "high" and "low" signal states referred to herein are relative, and correspond to the p-channel and n-channel devices shown in the specific embodiment. If the p and n conductivities of the device were reversed, the signal states would be "low" and "high" accordingly. What has been described is a self-timed precharge generation circuit which is fast and extremely reliable, is free of any timing skew problems, and fits well with the existing architecture of the state of the art random access memories.

## Claims

1. A circuit for generating a precharge clock output signal for a memory array, characterized by

    a plurality of identical falling edge detector means (10), each of which is connected to a separate memory array wordline (16) and is responsive to a signal change on the associated wordline from a high to a low signal state for producing an output signal which changes from a low to a high signal state in response to the wordline high to low wordline signal change,

    an X-line complement means (12) connected to the outputs (37) of all the falling edge detector means (10) for producing an output signal which changes from a high to a low signal state in response to a low to high output signal change from any of the falling edge detector means, and

    a precharge generator means (14) connected to the output (19) of the X-line complement means for producing a precharge clock output signal (45) in response to the high to low signal state change of the output signal produced by the X-line complement means (12), so that the precharge clock output signal is produced in response to the high to low wordline signal state change.

2. A circuit according to claim 1, in which the falling edge detector means (10) includes first and second switching devices (17, 23) connected respectively between first and second nodes (30, 32) and a low signal state level, the first and second switching devices being turned off by a second reset signal ($\emptyset_2$) which is the complement of a first reset signal ($\emptyset_1$), placing the first node (30) at a high signal state and the second node (32) at a low signal state when the wordline signal to the falling edge detector changes from the low to the high signal state, and a falling edge detector output lead connected to the second node (32) to provide the falling edge detector output signal.

3. A circuit according to claim 2, in which, in response to a high to low wordline signal state changes, the second reset signal ($\emptyset_2$) remains at the low signal state, the first node (30) remains at the high signal state, and the second node (32) rises from the low to the high signal state, thus providing the low to high output signal state change from the falling edge detector means in response to the high to low wordline signal state change.

4. A circuit according to claim 2 or 3, in which the falling edge detector means (10) includes a third node (24) and a third switching device (36) connected between the second and third nodes, so that, when the wordline signal changes from the low to the high state placing the first node (30) at the high signal state, the third node (24) changes from high to low signal state, thereby turning said third switching device (36) on and placing the second node (32) at the low signal state, and, when the wordline signal changes from the high to the low state and the first node (30) remains at the high signal state, the third node (24) goes to a high signal state and the third transistor device (36) remains on, such that the second node (32) changes from the low to high signal state.

5. A circuit output signal according to any preceding claim, in which the X-line complement means (12) is a NOR circuit connected to a first reset signal ($\emptyset_1$), and including a plurality of switching devices (60), each connected to one of the output leads (37) of the falling edge detector means (10) and responsive to the output signals thereon which change from low to high signal state for producing a high to low output signal state change.

6. A circuit according to any preceding claim, in which the precharge generator means (14) includes a first node (43) connected through a first switching means (70, 72) to the the output (19) of the X-line complement means (12) and through a second switching means (74) to the first and second reset signals ($\emptyset_1$, $\emptyset_2$), the first node (43) of the precharge generator means (14) changing from low to high signal state when the output signal from the X-line complement means (12) change from high to low state and a reset signal is present, and in which the precharge clock output signal (45) changes from high to low signal state in response to the first node (43) of the precharge generator means (14) changing from low to high signal state, the precharge clock output signal going to the low signal state only when the wordline (16) resets.

**Revendications**

1. Circuit pour produire un signal de sortie d'horloge de précharge pour un agencement mémoire, caractérisé en ce qu'il comprend une pluralité de moyens de détecteur de front descendant identiques (10), dont chacun est connecté à une ligne de mots séparée d'un agencement mèmoire (16) et sensible à un changement de signal sur la ligne de mots associée depuis un état de signal de niveau haut à un état de signal de niveau bas pour produire un signal de sortie qui change d'un état de signal de niveau bas à un état de signal de niveau haut en réponse au changement du signal de niveau haut de la ligne de mots au signal de ligne de mots à l'état bas, un moyen de complément de lignes X (12) connecté aux sorties (37) de tous les moyens de détecteur de front descendant (10) pour produire un signal de sortie qui change d'un état de signal de niveau haut vers un état de signal de niveau bas en réponse à un changement du signal de sortie de niveau bas vers le niveau haut de l'un quelconque des moyens de détecteur de front descendant, et un moyen de générateur de précharge (14) connecté à la sortie (19) du moyen de complément de lignes X pour produire un signal de sortie d'horloge de précharge (45) en réponse au changement d'état du signal de niveau haut vers l'état de signal de niveau bas du signal de sortie produit par le moyen de complément de lignes X (12), de sorte que le signal de sortie d'horloge de précharge est produit en réponse au changement d'état du signal de ligne de mots de l'état du niveau haut vers le niveau bas.

2. Circuit selon la revendication 1, dans lequel les moyens de détecteur de front descendant (10) comporte des premier et second dispositifs de commutation (17, 23) connectés respectivement entre des premier et second noeuds (30, 32) et un niveau d'état de signal bas, les premier et second dispositifs de commutation étant bloqués par un second signal de remise à l'état initial ($\emptyset_2$) qui est le complément d'un premier signal de remise à l'état initial ($\emptyset_1$), plaçant le premier noeud (30) à l'état de signal haut et le second noeud (32) à l'état de signal bas lorsque le signal de ligne de mots vers le détecteur de front descendant change de l'état de signal bas vers l'état de signal haut, et un fil de sortie du détecteur de front descendant connecté au second noeud (32) pour délivrer le signal de sortie du détecteur de front descendant.

3. Circuit selon la revendication 2, dans lequel, en réponse à un changement de l'état du signal de ligne de mots de l'état haut vers l'état bas, le second signal de remise à l'état initial ($\emptyset_2$) reste à l'état de signal bas, le premier noeud (30) reste à l'état de signal haut, et le second noeud (32) s'élève de l'état de signal bas vers l'état de signal haut, délivrant ainsi le changement d'état de signal de sortie de l'état bas vers l'état haut depuis le moyen de détecteur de front descendant en réponse au changement d'état de signal de ligne de mots de l'état haut vers l'état bas.

4. Circuit selon les revendications 2 ou 3, dans lequel les moyens de détecteur de front descendant (10) comporte un troisième noeud (24) et un troisième dispositif de commutation (36) connecté entre les second et troisième noeuds, de sorte que lorsque les changements de signal de ligne de mots de l'état bas vers l'état haut place le premier noeud (30) à l'état de signal haut, le troisième noeud (24) change de l'état de signal haut vers l'état bas, rendant conducteur de ce fait le troisième dispositif de commutation (36) et plaçant le second noeud (32) à l'état de signal bas, et lorsque le signal de ligne de mots change de l'état haut vers l'état bas et que le premier noeud (30) reste à l'état de signal haut, le troisième noeud (24) passe à l'état de signal haut et le troisième dispositif à transistor (36) reste conducteur, de sorte que le second noeud (32) change de l'état de signal bas vers l'état de signal haut.

5. Circuit selon l'une quelconque des revendications précédentes, dans lequel le moyen de complément de lignes X (12) est un circuit NON OU connecté à un premier signal de remise à l'état initial (ø₁), et comportant une pluralité de dispositifs de commutation (60), chacun connecté à un fil des fils de sortie (37) des moyens de détecteur de front descendant (10) et répondant aux signaux de sortie sur ceux-ci qui changent d'un état de signal de niveau bas vers le niveau haut pour produire un changement d'état de signal de sortie de l'état haut vers l'état bas.

6. Circuit selon l'une quelconque des revendications précédentes, dans lequel le moyen de générateur de précharge (14) comporte un premier noeud (43) connecté à travers un premier moyen de commutation (70, 72) à la sortie (19) du moyen de complément de lignes X (12) et à travers un second moyen de commutation (74) aux premier et second signaux de remise à l'état initial (ø₁, ø₂), le premier noeud (43) du moyen de générateur de précharge (14) changeant de l'état de signal du niveau bas vers le niveau haut lorsque le signal de sortie provenant du moyen de complément de lignes X (12) change de l'état de niveau haut vers le niveau bas et un signal de remise à l'état initial est présent, et dans lequel le signal de sortie d'horloge de précharge (45) change de l'état de signal de niveau haut vers le niveau bas en réponse au premier noeud (43) du moyen de générateur de précharge (14) changeant de l'état de signal de niveau bas vers le niveau haut, le signal de sortie d'horloge de précharge passant à l'état de signal de niveau bas seulement lorsque la ligne de mots (16) est remise à l'état initial.

## Patentansprüche

1. Schaltung zum Erzeugen eines Vorlade-Taktgeberausgangssignals für eine Speicheranordnung, gekennzeichnet durch

eine Mehrzahl identischer Detektormittel (10) für eine fallende Flanke, bei welchen jedes mit einer getrennten Speicheranordnung-Wortzeile (16) verbunden ist und auf eine Signaländerung in der zugeordneten Wortzeile von einem hochliegenden zu einem niedrigliegenden Signalzustand zum Erzeugen eines Ausgangssignals anspricht, das von einem niedrigliegenden zu einem hochliegenden Signalzustand entsprechend der hoch-zu-niedrig-Wortzeilensignaländerung einer Wortzeile wechselt,

ein X-Zeile-Komplementiermittel (12), das mit den Ausgängen (37) aller Detektormittel (10) für eine fallende Flanke zum Erzeugen eines Ausgangssignals verbunden ist, das von einem hochliegenden zu einem niedrigliegenden Signalzustand entsprechend einer niedrig-zu-hoch Ausgangssignaländerung bei irgendeinem der Detektormittel für eine fallende Flanke wechselt und

ein Vorladegeneratormittel (14), das mit dem Ausgang (19) des X-Zeile-Komplementiermittels verbunden ist, um ein Vorlade-Taktgeberausgangssignal (45) entsprechend der hochliegend-zu-niedrigliegend Signalzustandsänderung des durch das X-Zeile-Komplementiermittel (12) erzeugten Ausgangssignals zu erzeugen, sodaß das Vorlade-Taktgeberausgangssignal entsprechend der hoch-zu-niedrig-Zustandsänderung eines Wortzeilensignals erzeugt wird.

2. Schaltung nach Anspruch 1, bei welcher das Detektormittel (10) für eine fallende Flanke aufweist: erste und zweite Schaltbauelemente (17, 23), die in dieser Reihenfolge zwischen erste und zweite Knoten (30, 32) und einen niedrigliegenden Signalzustandspegel geschaltet sind, wobei die ersten und zweiten Schaltbauelemente durch ein zweites Rücksetzsignal (ø₂) ausgeschaltet werden, welches das Komplement eines ersten Rücksetzsignals (ø₁) ist und der erste Knoten (30) auf einen hochliegenden Signalzustand und der zweite Knoten (32) auf einen niedrigliegenden Signalzustand gebracht wird, wenn das Wortzeilensignal zu dem Detektor für eine fallende Flanke von dem niedrigliegenden zu dem hochliegenden Signalzustand wechselt und eine Ausgangsleitung für den Detektor für eine fallende Flanke, die mit dem zweiten Knoten (32) verbunden ist, um das Ausgangssignal des Detektors für eine fallende Flanke zu liefern.

3. Schaltung nach Anspruch 2, bei welcher das zweite Rücksetzsignal ($\emptyset_2$) in dem niedrigliegenden Signalzustand bleibt, der erste Knoten (30) in dem hochliegenden Signalzustand bleibt und sich der zweite Knoten (32) von dem niedrigliegenden zu dem hochliegenden Signalzustand, entsprechend hoch-zu-niedrig Signalzustandsänderungen einer Wortzeile anhebt, wodurch die niedrig-zu-hoch Ausgangssignalzustandsänderung bei dem Detektormittel für eine fallende Flanke entsprechend der hoch-zu-niedrig Signalzustandsänderung einer Wortzeile geliefert wird.

4. Schaltung nach Anspruch 2 oder 3, bei welcher das Detektormittel (10) für eine fallende Flanke einen dritten Knoten (24) und ein drittes Schaltbauelement (36) aufweist, das zwischen den zweiten und dritten Knoten geschaltet ist, sodaß, wenn das Wortzeilensignal von dem niedrigliegenden zu dem hochliegenden Zustand wechselt, wobei der erste Knoten (30) auf den hochliegenden Signalzustand gebracht wird, der dritte Knoten (24) von einem hochliegenden zu einem niedrigliegenden Signalzustand wechselt, wodurch das dritte Schaltbauelement (36) eingeschaltet wird und der zweite Knoten (32) auf den niedrigliegenden Signalzustand gebracht wird und, wenn das Wortzeilensignal von dem hochliegenden zu dem niedrigliegenden Zustand wechselt und der erste Knoten (30) in dem hochliegenden Signalzustand bleibt, der dritte Knoten (24) in einen hochliegenden Signalzustand übergeht und das dritte Transistorbauelement (36) eingeschaltet bleibt, sodaß der zweite Knoten (32) von dem niedrigliegenden zu dem hochliegenden Signalzustand wechselt.

5. Schaltung(Ausgangssignal) nach irgend einem vorgehenden Anspruch, bei welchem das X-Zeile-Komplementiermittel (12) eine NOR-Schaltung ist, die an ein erstes Rücksetzsignal ($\emptyset_1$) geschaltet ist und eine Mehrzahl von Schaltbauelementen (60) aufweist, bei welchen jedes mit einer der Ausgangsleitungen (37) des Detektormittels (10) für eine fallende Flanke verbunden ist und auf die darauf liegenden Ausgangssignale anspricht, die von einem niedrigliegenden zu einem hochliegenden Signalzustand wechseln, um eine hoch-zu-niedrig Ausgangssignal-Zustandsänderung zu erzeugen.

6. Schaltung nach irgend einem vorgehenden Anspruch, bei welcher das Vorladegeneratormittel (14) einen ersten Knoten (43) aufweist, der durch ein erstes Schaltmittel (70, 72) an den Ausgang (19) des X-Zeile-Komplementiermittels (12) und durch ein zweites Schaltmittel (74) an die ersten und zweiten Rücksetzsignale ($\emptyset_1$, $\emptyset_2$) gelegt ist, wobei der erste Knoten (43) des Vorladegeneratormittels (14) von einem niedrigliegenden zu einem hochliegenden Signalzustand wechselt, wenn das Ausgangssignal bei dem X-Zeile-Komplementiermittel (12) von einem hochliegenden zu einem niedrigliegenden Zustand wechselt und ein Rücksetzsignal vorhanden ist und bei welcher das Vorlade-Taktgeberausgangssignal (45) von einem hochliegenden zu einem niedrigliegenden Signalzustand in Einklang damit wechselt, daß der erste Knoten (43) des Vorladegeneratormittels (14) von einem niedrigliegenden zu einem hochliegenden Signalzustand wechselt, wobei das Vorlade-Taktgeberausgangssignal nur dann in den niedrigliegenden Signalzustand übergeht, wenn die Wortzeile (16) zurücksetzt.

FIG. 1

FIG. 2

EP 0 190 823 B1

FIG. 3

FIG. 5

9

FIG. 4

FALLING EDGE
DETECTOR MEANS 10

FALLING EDGE
DETECTOR MEANS

PRECHARGE
CLOCK
OUTPUT

X LINE
COMPLEMENT MEANS

EP 0 190 823 B1